# EUROPEAN PATENT APPLICATION

(11) **EP 2 940 742 A1**
(43) Date of publication of application: **04.11.2015**
(21) Application number: 13866873.6
(22) Date of filing: 26.12.2013
(51) Int. Cl.: H01L 33/50, C09K 11/59, F21V 9/16, F21Y 101/02

(54) **LIGHT EMITTING DEVICE**

(30) Priority: 28.12.2012 JP 2012287388
(71) Applicant: Shin-Etsu Chemical Co., Ltd., Tokyo 100-0004 (JP)
(72) Inventor: TSUMORI Toshihiro, Echizen-shi Fukui 915-8515 (JP); MINOWA Takehisa, Echizen-shi Fukui 915-8515 (JP); KANEYOSHI Masami, Echizen-shi Fukui 915-8515 (JP); WATAYA Kazuhiro, Echizen-shi Fukui 915-8515 (JP)
(74) Representative: Stoner, Gerard Patrick
(86) International application number: PCT/JP2013/084787
(87) International publication number: WO 2014/104152

(57) **Abstract**

Disclosed is a blue-light emitting device, or a pseudo-white-light emitting device, including an LED light source that includes, as a light emission component, blue light having a wavelength of from 420 to 490 nm. In this light emitting device, a color-renderability improvement member including a complex fluoride fluorophore that absorbs blue light and emits red light and that is represented by A₂(M₁₋ₓMnₓ)F₆ (in the formula: M is at least one type of tetravalent element selected from Si, Ti, Zr, Hf, Ge, and Sn; A is at least one type of alkali metal selected from Li, Na, K, Rb, and Cs and including at least Na and/or K; and x is from 0.001 to 0.3) is arranged in a location that is outside a region onto which light parallel to the light emission axis of the LED light source is emitted, said region being within a region onto which light is emitted from the LED light source.

## Description

### TECHNICAL FIELD

This invention relates to a light-emitting device using blue light-emitting diodes (blue LEDs) such as a general purpose illuminating device, backlight source or headlight source, which is improved in the color rendering of illuminating light.

### BACKGROUND ART

Light-emitting diodes (LEDs) belong to a class of the most efficient light sources among currently available light sources. In particular, white LEDs find a rapidly expanding share in the market as the next-generation light source to replace incandescent lamps, fluorescent lamps, cold cathode fluorescent lamps (CCFL) for backlight, and halogen lamps. As one configuration for white LED, an LED device (LED lighting device) constructed by combining a blue light-emitting diode (blue LED) with a phosphor capable of emitting light of longer wavelength, for example, yellow or green light upon blue light excitation is implemented on a commercial basis.

Among others, the current mainstream of the LED lighting device is a pseudo-white LED device comprising a blue LED and a phosphor capable of emitting yellow light (referred to as yellow phosphor, hereinafter). Known examples of the yellow phosphor include Y₃Al₅O₁₂ : Ce, (Y,Gd)₃(Al,Ga)₅O₁₂:Ce, (Y, Gd)₃Al₅O₁₂:Ce,Tb₃Al₅O₁₂:Ce, CaGa₂S₄: Eu, (Sr,Ca,Ba)₂SiO₄:Eu, and Ca-α-SiAlON:Eu.

In many of these pseudo-white LED devices, for example, a phosphor member (wavelength conversion member) composed of silicone resin or glass having yellow phosphor particles dispersed therein is disposed close to and forward of the blue LED whereby the phosphor emits yellow fluorescence of center wavelength around 570 nm (wavelength 510 to 600 nm) in response to incident blue light of wavelength around 450 nm. The yellow light is combined with the light of the blue LED transmitted by the wavelength conversion member to produce white light.

However, the pseudo-white LED device using a typical yellow phosphor, Y₃Al₅O₁₂:Ce emits light containing little of a green wavelength component of wavelength near 500 nm or a red wavelength component of wavelength 600 nm or longer. As a result, the light output of the pseudo-white LED device has a color rendering inferior to natural light.

Thus, from the past, studies are made on the color rendering of white LED devices to improve their red light emission characteristics so as to endow their light output with a warm comfortable sense. One of such studies is to further incorporate in a wavelength conversion member of a pseudo-white LED device, a phosphor capable of emitting red light (referred to as red phosphor, hereinafter, such as Sr-CaAlSiN₃:Eu or manganese-activated tetravalent metal fluoride salt phosphor) containing more a fluorescent component of longer wavelength region than the yellow phosphor or a phosphor capable of emitting green light (referred to as green phosphor, hereinafter). See, for example, JP-A 2009-280763 (Patent Document 1), JP-A 2010-045328 (Patent Document 2), JP-A 2010-093132 (Patent Document 3), and WO 2009/110285 (Patent Document 4).

However, the method of mixing the yellow or green phosphor with the red phosphor has the problems that the emission efficiency is reduced in proportion to a supplementary amount of red phosphor, and a certain type of red phosphor absorbs yellow light from the yellow phosphor to further detract from the emission efficiency. Also, when a wavelength conversion member is manufactured by the widespread potting method of mixing and dispersing both the phosphors in a silicone resin or epoxy resin, coating the resin to the front surface of blue LED to form a wavelength conversion layer, the proportion of wavelength conversion per LED varies due to a difference of the phosphor dispersion state between LEDs. It is thus difficult to produce light emission of uniform color in satisfactory yields.

### CITATION LIST

### Patent Documents

Patent Document 1: JP-A 2009-280763
Patent Document 2: JP-A 2010-045328
Patent Document 3: JP-A 2010-093132
Patent Document 4: WO 2009/110285

### SUMMARY OF INVENTION

### Technical Problem

An object of the invention, which has been made under the above-mentioned circumstances, is to provide a light-emitting device capable of producing a light output of high color rendering without sacrifice of emission efficiency.

### Solution to Problem

Making extensive investigations to solve the outstanding problems and determining the extent of improvement by the addition of red light to pseudo-white light in the prior art, the inventors have found that when red light is added to yellow light to produce pseudo-white light as the light output, in a light quantity (photon quantity) of about 5 to 10%, white light of significantly improved color rendering is obtained. Further studying how to obtain such red light, the inventors have found that when a color rendering-improving member comprising a red phosphor is disposed in an LED light-emitting device capable of emitting pseudo-white light, at a position that is inside a region over which the LED light source irradiates light, but outside a region over which light parallel to the light emission axis of the LED light source is irradiated, fluorescent light necessary to improve the color rendering of light output is obtainable. The present invention is predicated on these findings.

Accordingly, the invention provides a light-emitting device as defined below.
[1] A light-emitting device for emitting blue light or pseudo-white light, comprising
   an LED light source capable of emitting light containing blue light of wavelength 420 to 490 nm as a component, having an axis of light emission, and
   a color rendering-improving member disposed at a position that is inside a region over which the LED light source irradiates light, but outside a region over which light parallel to the light emission axis of the LED light source is irradiated, said color rendering-improving member comprising a phosphor capable of absorbing the blue light and emitting red light.
[2] The light-emitting device of [1] wherein said color rendering-improving member is disposed at a position corresponding to an exit angle of 10° to 120° relative to the light emission axis of the LED light source.
[3] The light-emitting device of [1] or [2] wherein said color rendering-improving member is disposed about the light emission axis of the LED light source so as to surround the light emission axis.
[4] The light-emitting device of any one of [1] to [3], further comprising a reflector disposed backward of the color rendering-improving member and the LED light source for reflecting light from the color rendering-improving member.
[5] The light-emitting device of any one of [1] to [4] wherein said phosphor is a complex fluoride phosphor having the formula (1):

   A₂(M₁₋ₓMnₓ)F₆ (1)

   wherein M is one or two or more of tetravalent elements selected from Si, Ti, Zr, Hf, Ge, and Sn, A is one or two or more of alkali metals selected from Li, Na, K, Rb, and Cs and containing at least Na and/or K, and x is a number of 0.001 to 0.3.
[6] The light-emitting device of [5] wherein the complex fluoride phosphor is manganese-activated potassium silicofluoride of the formula: K₂(Si₁₋ₓMnₓ)F₆ wherein x is as defined above.
[7] The light-emitting device of [5] or [6] wherein the color rendering-improving member consists of the complex fluoride phosphor.
[8] The light-emitting device of [5] or [6] wherein the color rendering-improving member is a molded resin having the complex fluoride phosphor dispersed therein.
[9] The light-emitting device of any one of [1] to [8] wherein the LED light source emits blue light, and the device further comprises a wavelength conversion member on the light emission axis of the LED light source, the wavelength conversion member comprising a phosphor capable absorbing the blue light and emitting light of different wavelength from the phosphor in the color rendering-improving member.
[10] The light-emitting device of any one of [1] to [8] wherein the LED light source emits white light.

### Advantageous Effects of Invention

In the light-emitting device of the invention, a color rendering-improving member containing a red phosphor is disposed at a position that is inside the region over which the LED light source irradiates light, but outside the irradiation region of light parallel to the light emission axis of the LED light source. Then a red component is added to the emission spectrum to achieve an improvement in color rendering. The color rendering-improving member need not be disposed on the light emission axis of the LED light source, and it may be disposed at any position where blue excitation light is incident, specifically at a position off the irradiation region of light parallel to the light emission axis, for example, near the reflector or near the lamp shade. It causes a minimal decline of emission efficiency.

### BRIEF DESCRIPTION OF DRAWINGS

[FIG. 1] FIG. 1 is a schematic perspective view showing components of a light-emitting device according to a first embodiment of the invention.
[FIG. 2] FIG. 2 is a schematic cross-sectional view showing the disposition of the color rendering-improving member in the light-emitting device of FIG. 1.
[FIG. 3] FIG. 3 is a schematic perspective view showing components of a light-emitting device according to another version of the first embodiment of the invention.
[FIG. 4] FIG. 4 is a schematic perspective view showing components of a light-emitting device according to a second embodiment of the invention.
[FIG. 5] FIG. 5 is a schematic perspective view showing components of a light-emitting device according to a third embodiment of the invention.
[FIG. 6] FIG. 6 is a schematic perspective view showing components of a pseudo-white LED lighting device used for evaluation in Examples.
[FIG. 7] FIG. 7 shows perspective images of emissions from the color rendering-improving member of Example 3 and the wavelength conversion member of Comparative Example 3.
[FIG. 8] FIG. 8 is a diagram showing the emission spectra of the light-emitting devices in Examples 5 to 12 and Comparative Example 5.

### DESCRIPTION OF EMBODIMENTS

The light-emitting device of the invention is described below.

The light-emitting device of the invention relates to an LED lighting fixture adapted to produce white light via wavelength conversion of excitation light from an LED light source by a phosphor.

Of prior art light-emitting devices of this type, there are widely used white LED devices comprising an LED chip serving as a light source and a yellow wavelength conversion layer formed forward of the LED chip by incorporating a yellow phosphor such as Y₃Al₅O₁₂:Ce³⁺ into an encapsulant resin. Also included in the LED devices are devices of the so-called remote phosphor structure in which an independent yellow wavelength conversion member of a large area is spaced apart from the front surface of a blue light-emitting LED chip by a distance of several millimeters to several tens of millimeters, for the purpose of improving the luminous intensity distribution of an LED device as a lighting fixture.

The light-emitting device of the remote phosphor structure is generally configured such that a lateral fraction of excitation light from the LED light source and a fraction of excitation light reflected by the wavelength conversion member are reflected by a reflector disposed backward of the LED light source, back to the wavelength conversion member again.

The inventors first attempted to combine the light-emitting device of the remote phosphor structure with a color rendering-improving member containing a red phosphor, for improving the color rendering as an LED lighting fixture. As a result, with respect to the light-emitting device of the remote phosphor structure including a reflector disposed backward of the LED light source, it has been found that the color rendering as an LED lighting fixture is improved when the color rendering-improving member is disposed at or near a position off the irradiation region of light parallel to the light emission axis of the LED light source.

Further the inventors attempted to combine the light-emitting device of the structure having a phosphor disposed on a blue LED chip with a color rendering-improving member containing a red phosphor, for improving the color rendering as an LED lighting fixture. As a result, with respect to the light-emitting device of the structure having a phosphor disposed on a blue LED chip, it has been found that the color rendering as an LED lighting fixture is improved when the color rendering-improving member is disposed at or near a position off the irradiation region of light parallel to the light emission axis of the LED light source.

That is, the light-emitting device of the invention is a light-emitting device for emitting white light containing a blue wavelength component, comprising an LED light source capable of emitting light containing at least a blue wavelength component, having an axis of light emission, and a color rendering-improving member disposed at a position that is inside a region over which the LED light source irradiates light, but outside a region over which light parallel to the light emission axis of the LED light source is irradiated, the color rendering-improving member comprising a phosphor capable of absorbing blue wavelength component light and emitting light containing a red wavelength component. On the assumption that a circumferential surface passes the periphery of the emissive surface of the LED light source and extends parallel to its light emission axis, the irradiation region of light parallel to the light emission axis refers to the region delimited and confined by this circumferential surface.

Specifically, in constructing a light-emitting device, a blue LED light source and a yellow (or green) wavelength conversion member are spaced a distance of several millimeters to several tens of millimeters, and a color rendering-improving member is disposed at such a position as not to substantially block excitation light exiting the light-emitting device directly forward, for thereby adding a red component to the emission spectrum to enable natural color reproduction. With this construction, since the color rendering-improving member is excited by light propagating laterally from the LED light source and light reflected by the wavelength conversion member, the attenuation of excitation light emitted from the LED light source in the emission axis direction, that causes a drop of illuminance of the lighting fixture, is minimal. Namely, the reduction of luminous quantity by chromaticity adjustment is minimal.

Further in constructing a light-emitting device, a color rendering-improving member is disposed at such a position as not to substantially block excitation light exiting the light-emitting device directly forward, typically in the periphery of the white LED light source, for thereby adding a red component to the emission spectrum to enable natural color reproduction. With this construction, since the color rendering-improving member is excited by light propagating laterally from the LED light source and light reflected by the wavelength conversion member, the attenuation of excitation light emitted from the LED light source in the emission axis direction, that causes a drop of illuminance of the lighting fixture, is minimal. Namely, the reduction of luminous quantity by chromaticity adjustment is minimal.

Below the light-emitting device of the invention is specifically illustrated.

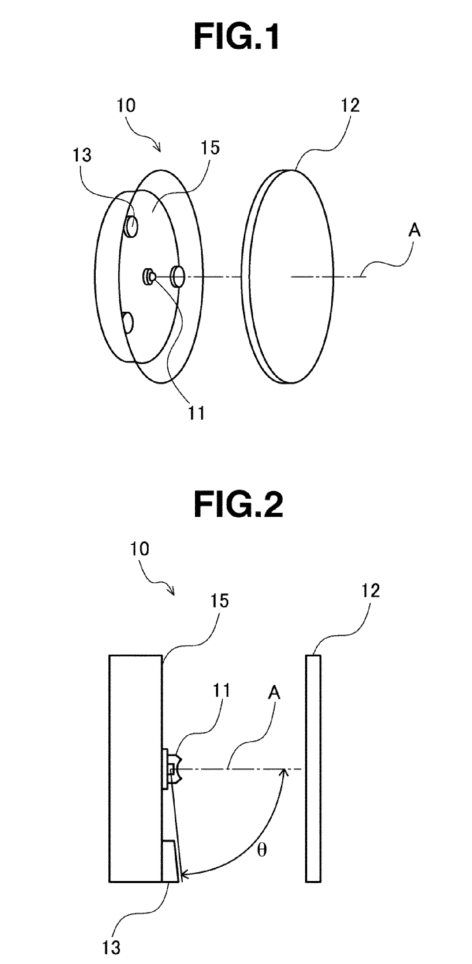

FIG. 1 is a perspective view showing components of a light-emitting device according to a first embodiment of the invention, illustrating an exemplary LED projector.

The light-emitting device of the invention is depicted at 10 in FIG. 1 as comprising an LED light source 11 capable of emitting blue light, having an axis of light emission A, a color rendering-improving member 13 disposed at a position that is inside a region over which the LED light source 11 irradiates light, but outside an irradiation region of light parallel to the light emission axis A, and a wavelength conversion member 12 disposed on light emission axis A and containing a phosphor capable of absorbing blue light and emitting light of different wavelength from the phosphor in the color rendering-improving member 13. Preferably the color rendering-improving member 13 is disposed at a position that does not block the region between the LED light source 11 and the wavelength conversion member 12 where the excitation light passes, for example, a position other than forward in the emission direction of the LED light source (e.g., lateral or backward position).

The LED light source 11 used herein should emit light capable of exciting the phosphors in the wavelength conversion member 12 and the color rendering-improving member 13 included in the light-emitting device 10, specifically blue light, preferably blue light of emission wavelength 420 to 490 nm, more preferably 440 to 470 nm. While the LED light source 11 is depicted in FIG. 1 as comprising a single LED chip, a light source comprising a plurality of LED chips is also preferable for LED lighting purpose.

The wavelength conversion member 12 is preferably a resin molding or glass-encapsulated part having a yellow or green phosphor dispersed therein. For example, it is a yellow wavelength conversion member in which a prior art well-known yellow phosphor such as Y₃Al₅O₁₂ : Ce³⁺ or Lu₃Al₅O₁₂ : Ce³⁺ is incorporated in a thermoplastic resin.

The content of the phosphor in the wavelength conversion member 12 is determined in consideration of the quantity of incident blue light, the quantity of light emitted in the yellow or green wavelength region, the transmittance of blue light, and the like. In the case of a wavelength conversion member of 2 mm thick containing Y₃Al₅O₁₂:Ce³⁺ phosphor, for example, a phosphor content of 1 to 4% by weight is preferable.

The color rendering-improving member 13 contains a red phosphor capable of absorbing blue light and emitting red light, specifically capable of absorbing blue light from the LED light source 11 (capable of emitting blue light) and emitting red light for thereby improving the color rendering of the light-emitting device.

Preferably the color rendering-improving member 13 contains a complex fluoride phosphor having the formula (1):

A₂(M₁₋ₓMnₓ)F₆ (1)

wherein M is one or more tetravalent elements selected from among Si, Ti, Zr, Hf, Ge, and Sn, A is one or more alkali metals selected from among Li, Na, K, Rb, and Cs and containing at least Na and/or K, and x is a number of 0.001 to 0.3, preferably 0.001 to 0.1.

The complex fluoride phosphor is a red phosphor having the above formula (1), specifically a manganese-activated complex fluoride phosphor having the structure of complex fluoride A₂MF₆ in which part of constituent element is replaced by manganese. In the Mn-activated complex fluoride phosphor, preferably the activator Mn is a replacement at the site of tetravalent element in A₂MFₑ, as tetravalent manganese (Mn⁴⁺), though the replacement site is not limited thereto. In this sense, the phosphor may also be expressed as A₂MF₆:Mn⁴⁺. Of these complex fluoride phosphors, manganese-activated potassium silicofluoride of the formula: K₂(Si₁₋ₓMnₓ)F₆ wherein x is as defined above is especially preferred.

The manganese-activated complex fluoride phosphor emits red light having an emission peak or maximum emission peak in the wavelength range of 600 to 660 nm, when excited by blue light of wavelength 420 to 490 nm, preferably 440 to 470 nm. The complex fluoride phosphor is also characterized by a low absorption of yellow light of wavelength around 500 nm.

It is noted that the complex fluoride phosphor of formula (1) may be one produced by a prior art well-known method, for example, by dissolving or dispersing a metal fluoride starting material in hydrofluoric acid, and heating the solution for evaporation to dryness.

Preferably, the color rendering-improving member 13 consists of the aforementioned complex fluoride phosphor. For example, it may be formed by applying the particulate complex fluoride phosphor onto a substrate in a two- or three-dimensional fashion. Its shape is not particularly limited as long as it is applicable to the light-emitting device 10.

Also preferably, the color rendering-improving member 13 is a resin molding having the complex fluoride phosphor dispersed therein. In this embodiment, the color rendering-improving member 13 may be of any shape like plate, disk, ring or honeycomb shape, because the shape is not particularly limited as long as it is applicable to the light-emitting device 10.

The phosphor is preferably particulate and its particle size is preferably 2 µm to 200 µm, more preferably 10 µm to 60 µm, expressed as a volume basis 50% cumulative particle diameter D50 in particle size distribution. If the particle size D50 is less than 2 µm, there is a risk of color rendering-improving effect being lost owing to declines of internal quantum efficiency and absorbance of the phosphor. If the particle size D50 exceeds 200 µm, it is likely that the dispersion of phosphor particles becomes non-uniform during preparation of the color rendering-improving member. For the measurement of particle size in the practice of the invention, a dry laser diffraction scattering method of spraying a test powder in air or dispersing a test powder suspended in air, irradiating laser light thereto, and determining a particle diameter from the diffraction pattern is preferable.

In the embodiment wherein the color rendering-improving member 13 is a resin molding having the complex fluoride phosphor dispersed therein, the content of manganese-activated complex fluoride phosphor in the color rendering-improving member 13, that is, the content of phosphor based on the resin is preferably 1 to 60% by weight, more preferably 3 to 20% by weight, and most preferably 5 to 10% by weight. If the phosphor content exceeds 60 wt%, a reduction of mechanical strength of the color rendering-improving member becomes a concern. In a low phosphor content of less than 1 wt%, the color rendering-improving effect is substantially reduced.

Although the resin used in the color rendering-improving member 13 is not particularly limited, preference is given to a thermoplastic resin which is chemically resistant to acids and alkalis and fully proof to humidity. The thermoplastic resin is also advantageous in that a color rendering-improving member may be readily prepared therefrom by such techniques as injection molding.

Since the manganese-activated complex fluoride phosphor can be thermally decomposed at a temperature in excess of 250°C, the temperature during preparation of the color rendering-improving member should preferably be kept equal to or below 250°C. On choice of the thermoplastic resin, a thermoplastic resin which can be molded at or below 250°C is preferably selected.

Examples of the light transmitting thermoplastic resin preferred for the color rendering-improving member 13 include polyolefins such as polypropylene, polystyrenes such as general purpose polystyrene (GPPS), and styrene copolymers such as styrene-maleic acid copolymers, styrene-methyl methacrylate copolymers and acrylonitrile-butadiene-styrene (ABS) copolymers. One or more resins selected from these are preferably used. These resins allow for satisfactory mixing of the phosphor, and ensure that a color rendering-improving member having high chemical resistance and humidity resistance is prepared.

As the thermoplastic resin used herein, a thermoplastic resin containing at least 40% by weight of polypropylene and/or polystyrene is more preferred. As the polypropylene, a polypropylene of random copolymer type containing ethylene units in a low content of 2 to 6% by weight is especially preferred, with an injection moldable polypropylene having a melt flow rate (MFR) of 5 to 30 g/10 min. as measured according to JIS K 7210 being most preferred.

To the resin of the color rendering-improving member 13, like prior art thermoplastic resin materials, additives such as antioxidant, stabilizers including photo-stabilizer and UV absorber, and mold lubricant may be compounded in an amount of 0.1 to 0.3% by weight, depending on a particular application.

In the practice of the invention, a member is preferably prepared by furnishing the thermoplastic resin and auxiliary agents as resin matrix and the manganese-activated complex fluoride phosphor in powder form, feeding them into a twin-screw extruder, milling them such that the phosphor powder is incorporated in the heated resin matrix, and heat molding the resin matrix into any desired shape for a particular application. For example, after the resin matrix and the phosphor are milled, the material may be directly molded into the desired thickness and shape suitable as a color rendering-improving member. Alternatively, once the material is molded into pellets, the pelleted material may be molded into a color rendering-improving member of the desired thickness and shape when necessary.

Preferably the color rendering-improving member 13 has a thickness of 0.05 to 50 mm. If the thickness is less than 0.05 mm, the color rendering-improving member 13 may become difficult to maintain mechanical strength. A thickness in excess of 50 mm may lead to a substantial loss of light entering the color rendering-improving member 13 by the resin although a thickness beyond the range is not always unacceptable.

The color rendering-improving member 13 thus obtained becomes a member in which red phosphor particles, typically manganese-activated complex fluoride phosphor particles are mixed with the preselected thermoplastic resin without alteration. The color rendering-improving member 13 emits red light of wavelength about 600 to 660 nm when excited by blue light of wavelength 420 to 490 nm. Accordingly, when the color rendering-improving member 13 is applied to a white LED device, red light is added to the emission spectrum of the device to achieve an improvement in color rendering. Also, an advantage is obtained when the manganese-activated complex fluoride phosphor is used in the color rendering-improving member 13. Since the manganese-activated complex fluoride phosphor has a lower absorbance of blue light than nitride phosphors such as Sr-CaAlSiN₃:Eu²⁺, it is avoided that only a portion of the member that receives blue light becomes emissive, and a portion of the member that receives blue light emits light on absorption of a part of the blue light, and transmits and scatters the remainder of the blue light to neighbor phosphor particles so that the color rendering-improving member 13 provides light emission over its entirety. That is, the color rendering-improving member 13 provides surface emission commensurate to its shape and dimensions, and is suitable as an auxiliary member for adjusting the chromaticity of light in the light-emitting device 10. By contrast, when a nitride or oxynitride phosphor such as Sr-CaAlSiN₃:Eu²⁺ is used as the red phosphor, the color rendering-improving effect becomes low because this phosphor has a high absorbance and so, only a portion of the member that receives blue light becomes emissive.

The disposition of the color rendering-improving member 13 may be determined from a balance between the quantity of red wavelength component light (red light) emitted in accordance with the luminous intensity distribution of the LED light source 11, and the quantity of light output of the light-emitting device. When the position of the color rendering-improving member 13 is expressed by an exit angle θ relative to the light emission axis A of the LED light source 11, as shown in FIG. 2, the exit angle θ is preferably in the range of 10° to 120°, more preferably 30° to 90°, and even more preferably 60° to 90°. A position corresponding to an exit angle of less than 10° may reduce the quantity of light output of the light-emitting device 10 whereas at a position corresponding to an exit angle of more than 120°, red light for chromaticity adjustment may be short.

Also preferably, the light-emitting device 10 includes a reflector 15 disposed backward of the color rendering-improving member 13 and LED light source 11 for reflecting light from the color rendering-improving member 13. For example, as shown in FIG. 2, the color rendering-improving member 13 is preferably disposed on the reflector 15 which is disposed backward of the LED light source 11.

Furthermore, for uniformity of light emission, the color rendering-improving member 13 is preferably disposed about the LED light source 11 so as to surround the light emission axis A, especially equally arranged with respect to the light emission axis A. For example, as shown in FIG. 1, a plurality of compact disk shaped color rendering-improving members 13 may be equally spaced on a common circle about the light emission axis A. Alternatively, a ring-shaped (or annular) color rendering-improving member 13 may be aligned with the light emission axis A. Then, while a light output exits the light-emitting device 10 in the direction of light emission axis A, red light exits the color rendering-improving member 13 uniformly around the light output. The resultant light output is preferable as the light-emitting device.

Since the light-emitting device 10 of the invention is constructed such that the phosphors in both the wavelength conversion member 12 and the color rendering-improving member 13 are excited by the excitation light from the common LED light source 11, uniform light of consistent chromaticity is produced without a difference in light emission which is often found in a light-emitting device comprising a plurality of LED light sources, due to variations of LED output and emission color. In the light-emitting device 10 of the invention wherein the color rendering-improving member 13 is excited by light propagating laterally from the LED light source 11 and light reflected by the wavelength conversion member 12, the attenuation of excitation light emitted from the LED light source 11 in the emission axis direction and fluorescence from the wavelength conversion member 12, that causes a drop of illuminance of the lighting fixture, is minimal. Also the light-emitting device 10 offers a high freedom of adjustment via simple adjustment because the wavelength conversion member 12 and color rendering-improving member 13 whose phosphor contents have been adjusted in proportion to the desired chromaticity and color rendering may be mounted upon assembly of the light-emitting device 10. Furthermore, since the wavelength conversion member 12 and color rendering-improving member 13 are spatially independent and apart from the LED light source (light-emitting chip), it is unlikely that the wavelength conversion member 12 and color rendering-improving member 13 are heated at high temperature. Thus the invention is suited as a high power light-emitting device.

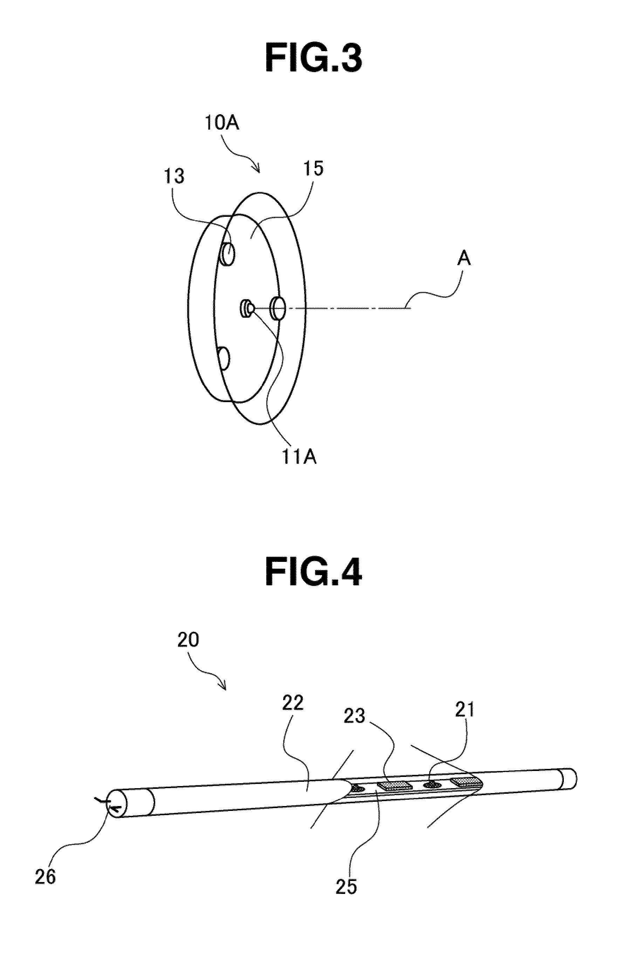

FIG. 3 is a perspective view showing components of a light-emitting device according to another version of the first embodiment of the invention.

The light-emitting device of the invention is depicted at 10A in FIG. 3 as comprising an LED light source 11A capable of emitting white light containing a blue light component and a color rendering-improving member 13 disposed at a position that is inside a region over which the LED light source 11A irradiates light, but outside an irradiation region of light parallel to the light emission axis A. The color rendering-improving member 13 is disposed off the direction in which light emitted by the LED light source 11A exits the light-emitting device 10A, and preferably at a position other than forward in the light emission direction of the LED light source 11A, for example, a lateral or backward position.

The LED light source 11A used herein is a light source of pseudo-white light emission, for example, comprising a blue LED chip capable of emitting blue light of wavelength 420 to 490 nm, preferably 440 to 470 nm, and a wavelength conversion layer which is formed by coating the surface of the blue LED with a resin coating composition containing a yellow or green phosphor.

The color rendering-improving member 13 and reflector 15 are the same as in FIG. 1. Preferably the color rendering-improving member 13 is disposed at a position corresponding to the same exit angle θ relative to the light emission axis of the LED light source 11A as in FIG. 1.

The light-emitting device 10A of the above-mentioned construction operates such that once the LED light source 11A emits white light (for example, white light consisting of blue light and yellow light), a fraction of the white light propagating laterally from the LED light source 11A enters the color rendering-improving member 13 where a blue light component in white light is converted to red light. Thus red light is available in a predetermined proportion, resulting in the light-emitting device producing white light of improved color rendering.

Next, FIG. 4 shows components of a light-emitting device according to a second embodiment of the invention. FIG. 4 is a partially cutaway view so that internal components in a center-to-right portion may be seen.

The inventive light-emitting device of linear tube type is depicted at 20 in FIG. 4 as comprising a linear tubular form of wavelength conversion member 22, a plate-shaped reflector 25 serving as a support, received within the linear tube, an LED light source 21 capable of emitting blue light, and a color rendering-improving member 23, the wavelength conversion member 22 comprising a phosphor capable of absorbing blue light and emitting light of different wavelength from the phosphor in the color rendering-improving member 23. The LED light sources 21 and color rendering-improving members 23 are disposed on the reflector 25 alternately in the longitudinal direction of the linear tube. In the illustrated embodiment, each LED light source 21 has a light emission axis perpendicular to the reflector 25, and the color rendering-improving member 23 is disposed at a position that is inside a region over which the LED light source 21 irradiates light, but outside an irradiation region of light parallel to the light emission axis. The color rendering-improving member 23 is disposed off the direction in which light emitted by the LED light source 21 exits the light-emitting device 20, and preferably at a position other than forward in the light emission direction of the LED light source 21, for example, a lateral or backward position. Electric power is supplied to the LED light sources 21 via electrodes 26 at the end of the linear tube.

The light-emitting device 20 of the above-mentioned construction operates such that once the LED light source 21 emits blue light, the blue light enters the wavelength conversion member 22 where a portion of blue light is absorbed by the phosphor therein and converted to yellow light, whereupon the yellow light emerges from the wavelength conversion member 22 together with the remainder of blue light transmitted by the wavelength conversion member 22. On the other hand, the color rendering-improving member 23 receives blue light propagating laterally from an adjacent LED light source 21 and blue light reflected by the wavelength conversion member 22, whereupon the blue light inputs are converted to red light by the color rendering-improving member 23. Thus blue light, yellow light and red light are available in a predetermined proportion, resulting in the light-emitting device 20 producing white light of improved color rendering.

Since the light-emitting device 20 of the invention is constructed such that the phosphors in both the wavelength conversion member 22 and the color rendering-improving member 23 are excited by the excitation light from the common LED light source 21, uniform light of consistent chromaticity is produced without a difference in light emission which is often found in a light-emitting device comprising a plurality of LED light sources, due to variations of LED output and emission color. In the light-emitting device 20 of the invention wherein the color rendering-improving member 23 is excited by light propagating laterally from the LED light source 21 and light reflected by the wavelength conversion member 22, the attenuation of excitation light emitted from the LED light source 21 in the emission axis direction and fluorescence from the wavelength conversion member 22, that causes a drop of illuminance of the lighting fixture, is minimal. Also the light-emitting device 20 offers a high freedom of adjustment via simple adjustment because the wavelength conversion member 22 and color rendering-improving member 23 whose phosphor contents have been adjusted in proportion to the desired chromaticity and color rendering may be mounted upon assembly of the light-emitting device 20. Furthermore, since the wavelength conversion member 22 and color rendering-improving member 23 are spatially independent and apart from the LED light source (light-emitting chip), it is unlikely that the wavelength conversion member 22 and color rendering-improving member 23 are heated at high temperature. Thus the invention is suited as a high power light-emitting device.

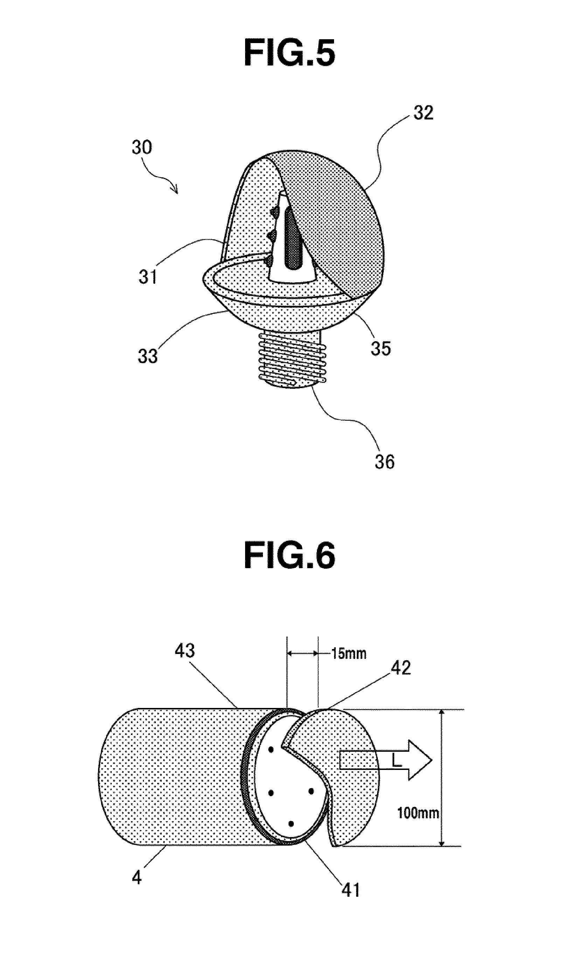

Next, FIG. 5 shows components of a light-emitting device according to a third embodiment of the invention. FIG. 5 is a partially cutaway view so that internal components in a center-to-left portion may be seen.

The inventive light-emitting device of the bulb type is depicted at 30 in FIG. 5 as comprising a bulb cover form of wavelength conversion member 32, a reflector 35 in the form of an upward tapered cylinder serving as a support, received within the bulb cover, an LED light source 31 capable of emitting blue light, and a plate-shaped color rendering-improving member 33, the wavelength conversion member 32 comprising a phosphor capable of absorbing blue light and emitting light of different wavelength from the phosphor in the color rendering-improving member 33. The LED light sources 31 and color rendering-improving members 33 are disposed on the peripheral surface of reflector 35 alternately in the circumferential direction of reflector 35. In the illustrated embodiment, each LED light source 31 has a light emission axis perpendicular to the peripheral surface of reflector 35, and the color rendering-improving member 33 is disposed at a position that is inside a region over which the LED light source 31 irradiates light, but outside an irradiation region of light parallel to the light emission axis of the LED light source. The color rendering-improving member 33 is disposed at a position lateral or backward of the LED light source 31 in the light emission direction. Electric power is supplied to the LED light sources 31 via a base 36.

The light-emitting device 30 of the above-mentioned construction operates such that once the LED light source 31 emits blue light, the blue light enters the wavelength conversion member 32 where a portion of blue light is absorbed by the phosphor therein and converted to light (yellow light or green light) including a yellow wavelength region (or green wavelength region), whereupon the light emerges from the wavelength conversion member 32 together with the remainder of blue light transmitted by the wavelength conversion member 32. On the other hand, the color rendering-improving member 33 receives blue light propagating laterally from an adjacent LED light source 31 and blue light reflected by the wavelength conversion member 32, whereupon the blue light inputs are absorbed by the red phosphor in the color rendering-improving member 33 and converted to red light. Thus blue light, yellow light and red light are available in a predetermined proportion, resulting in the light-emitting device 30 producing white light of improved color rendering.

Since the light-emitting device 30 of the invention is constructed such that the phosphors in both the wavelength conversion member 32 and the color rendering-improving member 33 are excited by the excitation light from the common LED light source 31, uniform light of consistent chromaticity is produced without a difference in light emission which is often found in a light-emitting device comprising a plurality of LED light sources, due to variations of LED output and emission color. In the light-emitting device 30 of the invention wherein the color rendering-improving member 33 is excited by light propagating laterally from the LED light source 31 and light reflected by the wavelength conversion member 32, the attenuation of excitation light emitted from the LED light source 31 in the emission axis direction and fluorescence from the wavelength conversion member 32, that causes a drop of illuminance of the lighting fixture, is minimal. Also the light-emitting device 30 offers a high freedom of adjustment via simple adjustment because the wavelength conversion member 32 and color rendering-improving member 33 whose phosphor contents have been adjusted in proportion to the desired chromaticity and color rendering may be mounted upon assembly of the light-emitting device 30. Furthermore, since the wavelength conversion member 32 and color rendering-improving member 33 are spatially independent and apart from the LED light source (light-emitting chip), it is unlikely that the wavelength conversion member 32 and color rendering-improving member 33 are heated at high temperature. Thus the invention is suited as a high power light-emitting device.

It is noted that the color rendering-improving member of the invention is applicable not only to a light-emitting device wherein a blue LED is used as the light source to produce white light, but also to a light-emitting device comprising an LED light source capable of emitting white light, that is, a light-emitting device comprising a pseudo-white LED light source capable of emitting light containing blue light of wavelength 420 to 490 nm as a component.

The light-emitting device of the invention is suited as a light-emitting device of remote phosphor technology wherein a wavelength conversion member is spaced apart from a blue LED light source by a gas or vacuum layer. Because of its light distribution characteristics distinguishable from general LED light-emitting devices, such as surface emission and a wide radiation angle, the remote phosphor system is best suited as illuminators for providing illumination over a wide area.

### EXAMPLES

Examples and Comparative Examples are given below for illustrating the invention, but the invention is not limited thereto.

### [Examples 1 to 4 and Comparative Examples 1 to 4]

An LED light-emitting device was manufactured under the following conditions.

On a twin-screw extruder, 0.5 kg of K₂(Si_{0.97}Mn_{0.03})F₆ phosphor powder having a particle size D50 of 17.6 µm was mixed with 4.5 kg of transparent polypropylene pellets, yielding the K₂(Si_{0.17}Mn_{0.03})F₆-loaded polypropylene pellets having a K₂(Si_{0.17}Mn_{0.03})F₆ content of 10 wt%.

Using a 20-t horizontal injection molding machine, the K₂(Si_{0.97}Mn_{0.03})F₆-loaded polypropylene pellets were molded into a ring-shaped color rendering-improving member having an inner diameter of 90 mm, an outer diameter of 96 mm and a thickness of 10 mm.

Also, pellets were prepared by incorporating 3 to 10 wt% of Y₃Al₅O₁₂:Ce³⁺ phosphor having a particle size D50 of 50 µm in polycarbonate resin. The polycarbonate pellets were injection molded into a disk-shaped yellow wavelength conversion member having a thickness of 2 mm and a diameter of 100 mm.

An LED light-emitting device was constructed as shown in FIG. 6 by placing the color rendering-improving member 43 on a circumference about a light emission axis of an LED light source 41, which was coplanar with an array of LED chips (LED light source) 41 included in an LED projector 4 (GL-RB100 by Hino Electronic Corp, using six 2-W blue LED chips XT-E Royal Blue by Cree, Inc.). Six LED chips 41 were situated within the ring of color rendering-improving member 43. At this point, the color rendering-improving member 43 was disposed at a position corresponding to an exit angle of 90° relative to the emission axis of the LED light source 41. Also, the wavelength conversion member 42 was disposed on the emission axis and forward of the LED projector 4 (in emission direction L) and spaced 15 mm apart from the LED chips 41. For comparison sake, an LED light-emitting device was also prepared in which the color rendering-improving member was omitted and only the wavelength conversion member was disposed.

Using an illuminance spectrophotometer CL-500A (Konica-Minolta Optics Co., Ltd.), the LED light-emitting device was measured at a spacing of 20 cm for illuminance, color temperature, average color rendering index Ra, and special color rendering index ΔR9 of white light, from which color rendering was judged. The results are shown in Table 1.

**[Table 1]**

| | Color rendering-improving member | Wavelength conversion member | Illuminance (lx) | Color temperature (K) | Average color rendering index Ra | Special color rendering index ΔR9 |
|---|---|---|---|---|---|---|
| | Phosphor content (wt%) | Phosphor content (wt%) | | | | |
| Example 1 | 10 | 10 | 3176 | 3320 | 68 | -9 |
| Example 2 | 10 | 5 | 3076 | 3794 | 75 | 16 |
| Example 3 | 10 | 4 | 2579 | 5895 | 90 | 92 |
| Example 4 | 10 | 3 | 2481 | 14710 | 80 | 12 |
| Comparative Example 1 | - | 10 | 2731 | 3539 | 60 | -59 |
| Comparative Example 2 | - | 5 | 3051 | 4154 | 66 | -40 |
| Comparative Example 3 | - | 4 | 2515 | 7235 | 81 | 28 |
| Comparative Example 4 | - | 3 | 2365 | * | * | * |

| | | | | | | |
|---|---|---|---|---|---|---|
| * unmeasurable because a blue component in white light under test is excessive relative to other color components | | | | | | |

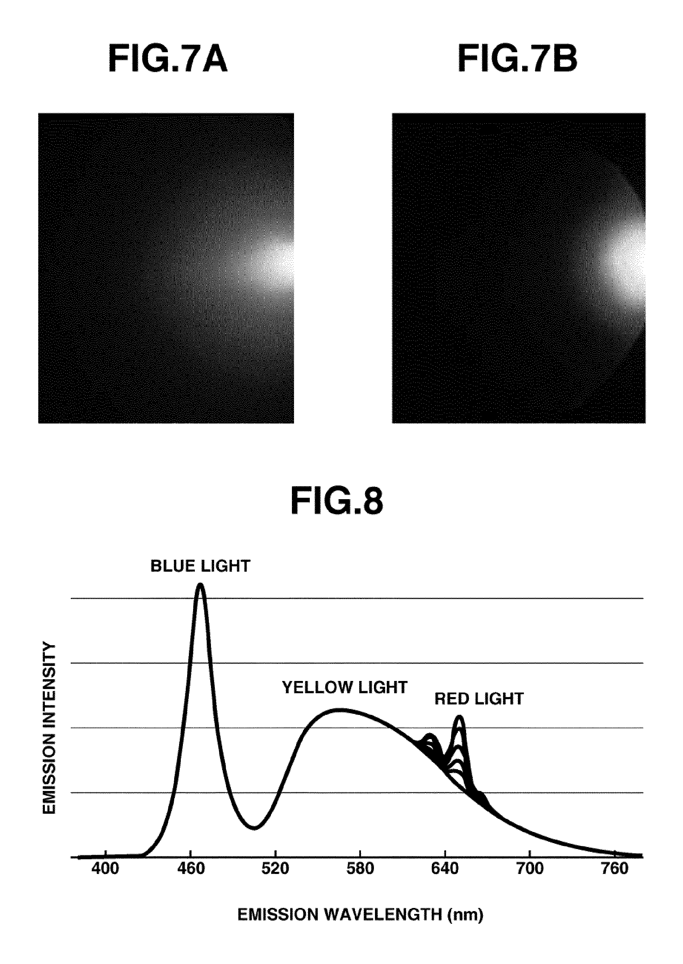

Using the above pellets for the color rendering-improving member of Example 3 and the wavelength conversion member of Comparative Example 3, a plate-shaped color rendering-improving member and wavelength conversion member of 2 mm thick and 40 mm squares were prepared. When light from a blue LED (wavelength 460 nm) was irradiated to the 40-mm square surface of the color rendering-improving member and wavelength conversion member in a perpendicular direction, the light emission from the color rendering-improving member and wavelength conversion member was visually observed on the back side opposed to the irradiated surface. FIG. 7 is a perspective image of such light emission. In the case of the wavelength conversion member of Comparative Example 3, as shown in FIG. 7(B), only the portion (right side in the figure) receiving blue light as excitation light looks bright due to light emission. In the case of the color rendering-improving member of Example 3, as shown in FIG. 7(A), not only the portion receiving blue light as excitation light, but also the surrounding portion (center to left side in the figure) provide light emission, indicating that the color rendering-improving member has a wide emission range.

It has been demonstrated that the inventive LED light-emitting device using the color rendering-improving member achieves significant improvements in average color rendering index Ra and special color rendering index ΔR9 over the LED light-emitting device using only the yellow wavelength conversion member. There is observed a tendency that illuminance is improved more or less.

### [Examples 5 to 12 and Comparative Example 5]

An LED light-emitting device was manufactured under the following conditions.

On a twin-screw extruder, K₂ (Si_{0.97}Mn_{0.03}) F₆ phosphor having a particle size D50 of 17.6 µm was mixed with transparent polypropylene pellets, yielding the K₂(Si_{0.97}Mn_{0.03})F₆-loaded polypropylene pellets having a K₂(Si_{0.97}Mn_{0.03}) F₆ content of 12 wt%.

Using a 20-t horizontal injection molding machine, the K₂(Si_{0.97}Mn_{0.03})F₆-loaded polypropylene pellets were molded into a rectangular plate-shaped color rendering-improving member of 25 mm x 30 mm and 2 mm thick.

Also, pellets were prepared by incorporating 4 wt% of Y₃Al₅O₁₂:Ce³⁺ phosphor having a particle size D50 of 50 µm in polymethyl methacrylate resin. The pellets were injection molded into a disk-shaped yellow wavelength conversion member having a thickness of 2 mm and a diameter of 100 mm.

An LED light-emitting device was constructed by placing 1 to 8 color rendering-improving members on the LED chip array plane of an LED projector GL-100 (input 15 W, emission wavelength 450 nm, Hino Electronic Corp.). At this point, the color rendering-improving member was disposed at a position corresponding to an exit angle of 90° relative to the emission axis of the LED light source. Also, the wavelength conversion member was disposed on the emission axis and forward of the LED projector and spaced 40 mm apart from the LED chips. For comparison sake, an LED light-emitting device was also prepared in which the color rendering-improving member was omitted and only the wavelength conversion member was disposed.

Using an illuminance spectrophotometer CL-500A (Konica-Minolta Optics Co., Ltd.), the LED light-emitting device thus manufactured was measured at a spacing of 20 cm for color temperature, deviation (Δuv), average color rendering index Ra, and special color rendering index ΔR9, from which color rendering was judged. The results are shown in Table 2. FIG. 8 illustrates the emission spectra of the devices.

**[Table 2]**

| | Number of color rendering-improving members | Color temperature (K) | Deviation (Δuv) | Average color rendering index Ra | Special color rendering index ΔR9 |
|---|---|---|---|---|---|
| Comparative Example 5 | 0 | 5928 | 0.0041 | 72 | -23 |
| Example 5 | 1 | 6053 | 0.0034 | 73 | -20 |
| Example 6 | 2 | 5921 | 0.0019 | 74 | -8 |
| Example 7 | 3 | 5883 | 0.0004 | 76 | 2 |
| Example 8 | 4 | 5726 | -0.0008 | 77 | 12 |
| Example 9 | 5 | 5629 | -0.0025 | 79 | 24 |
| Example 10 | 6 | 5473 | -0.0015 | 78 | 22 |
| Example 11 | 7 | 5397 | -0.0019 | 79 | 25 |
| Example 12 | 8 | 5352 | -0.0022 | 79 | 28 |

It is evident from the above that as the number of color rendering-improving members according to the invention is increased, the average color rendering index Ra and special color rendering index ΔR9 are further improved. As shown in FIG. 8, the quantity of red light is increased without substantially changing the quantity of yellow light.

Although the invention has been described with reference to the embodiments illustrated in the drawing, the invention is not limited thereto, and other embodiments may occur to, or various additions, changes and deletions may be made by those skilled in the art. All such embodiments fall in the scope of the invention as long as the advantages and results of the invention are obtainable.

### REFERENCE SIGNS LIST

- 10, 10A, 20, 30: light-emitting device
- 11, 11A, 21, 31, 41: LED light source
- 12, 22, 32, 42: wavelength conversion member
- 13, 23, 33, 43: color rendering-improving member
- 15, 25, 35: reflector
- 26: electrode
- 36: base
- 4: LED projector
- A: light emission axis
- L: light emission direction

## Claims

1. A light-emitting device for emitting blue light or pseudo-white light, comprising
an LED light source capable of emitting light containing blue light of wavelength 420 to 490 nm as a component, having an axis of light emission, and
a color rendering-improving member disposed at a position that is inside a region over which the LED light source irradiates light, but outside a region over which light parallel to the light emission axis of the LED light source is irradiated, said color rendering-improving member comprising a phosphor capable of absorbing the blue light and emitting red light.

2. The light-emitting device of claim 1 wherein said color rendering-improving member is disposed at a position corresponding to an exit angle of 10° to 120° relative to the light emission axis of the LED light source.

3. The light-emitting device of claim 1 or 2 wherein said color rendering-improving member is disposed about the light emission axis of the LED light source so as to surround the light emission axis.

4. The light-emitting device of any one of claims 1 to 3, further comprising a reflector disposed backward of the color rendering-improving member and the LED light source for reflecting light from the color rendering-improving member.

5. The light-emitting device of any one of claims 1 to 4 wherein said phosphor is a complex fluoride phosphor having the formula (1) :
A₂(M₁₋ₓMnₓ)F₆ (1)
wherein M is one or two or more of tetravalent elements selected from Si, Ti, Zr, Hf, Ge, and Sn, A is one or two or more of alkali metals selected from Li, Na, K, Rb, and Cs and containing at least Na and/or K, and x is a number of 0.001 to 0.3.

6. The light-emitting device of claim 5 wherein the complex fluoride phosphor is manganese-activated potassium silicofluoride of the formula: K₂(Si₁₋ₓMnₓ)F₆ wherein x is as defined above.

7. The light-emitting device of claim 5 or 6 wherein the color rendering-improving member consists of the complex fluoride phosphor.

8. The light-emitting device of claim 5 or 6 wherein the color rendering-improving member is a molded resin having the complex fluoride phosphor dispersed therein.

9. The light-emitting device of any one of claims 1 to 8 wherein the LED light source emits blue light, and the device further comprises a wavelength conversion member on the light emission axis of the LED light source, the wavelength conversion member comprising a phosphor capable absorbing the blue light and emitting light of different wavelength from the phosphor in the color rendering-improving member.

10. The light-emitting device of any one of claims 1 to 8 wherein the LED light source emits white light.
